# EUROPÄISCHE PATENTSCHRIFT

(11) **EP 3 245 672 B1**
(45) Veröffentlichungstag und Bekanntmachung des Hinweises auf die Patenterteilung: **28.06.2023**
(21) Anmeldenummer: 15813450.2
(22) Anmeldetag: 21.12.2015
(51) Int. Cl.: H01L 23/00, H01L 23/34, H01L 25/07

(54) **KONTAKTANORDNUNG UND LEISTUNGSMODUL**
CONTACT ARRANGEMENT AND POWER MODULE
AGENCEMENT DE CONTACTS ET MODULE DE PUISSANCE

(30) Priorität: 14.01.2015 DE 102015200480
(43) Veröffentlichungstag der Anmeldung: 22.11.2017
(73) Patentinhaber: Robert Bosch GmbH, 70442 Stuttgart (DE)
(72) Erfinder: SCHOENKNECHT, Andreas, 71272 Renningen (DE); AYDOGMUS, Irfan, 72622 Nuertingen (DE); ADAM, Boris, 71126 Gaeufelden (DE); HIRSCH, Michele, 73730 Esslingen (DE); SUENNER, Thomas, 70178 Stuttgart (DE); KLUTHE, Christian, 70794 Filderstadt (DE); MESSNER, Oliver, 70184 Stuttgart (DE); SINN, Peter, 74199 Untergruppenbach (DE)
(86) Internationale Anmeldenummer: PCT/EP2015/080726
(87) Internationale Veröffentlichungsnummer: WO 2016/113080

(56) Entgegenhaltungen:
- WO-A1-2014/103036
- DE-A1-102006 001 874
- DE-A1-102007 056 581
- DE-A1-102008 026 541
- US-A1- 2002 167 065

## Beschreibung

Die Erfindung betrifft eine Kontaktanordnung zumindest eines Leistungshalbleiters mit einem Schaltungsträger einer Schaltung sowie ein die Kontaktanordnung umfassendes elektronisches Leistungsmodul.

### Stand der Technik

In vielen elektrischen Anwendungen kommen große Spannungen und Ströme zum Tragen. Diese müssen für den Betrieb eines elektrischen und/oder elektronischen Gerätes in einer definierten Form bereitgestellt werden. Hierzu kommen in besonderer Weise Leistungsmodule zum Einsatz, wie beispielsweise Gleichrichter, Wechselrichter oder Umrichter. Derartige Leistungsmodule umfassen zumindest einen Leistungshalbleiter, welcher durch eine Ansteuerschaltung in definierter Form betrieben wird. Infolge von Leistungsverlusten oder durch die Umgebungstemperatur erwärmen derartige Leistungshalbleiter und sind somit im Betrieb temperaturbelastet. Es sind verschiedene Maßnahmen bekannt, die durch eine geeignete Entwärmung des Leistungshalbleiters versuchen, die Temperatur für den Leistungshalbleiter zu reduzieren oder zu begrenzen. Grundsätzlich ist es vorteilhaft, den Leistungshalbleiter mit maximalen Strömen zu betreiben, welche noch eine Temperaturbelastung in einem für den Betrieb des Leistungshalbleiters unkritischen Bereich belässt.

Zur Überwachung der Temperaturbelastung ist es bekannt, im Leistungsmodul schaltungstechnisch eine Temperaturmessung zu integrieren. Dies erfolgt beispielsweise durch einen Shunt oder einen SMD-Widersand (surface-mounteddevice), welcher auf dem Schaltungsträger, auf welchem der Leistungshalbleiter angeordnet ist, aufgelötet wird. Dadurch ist der SMD-Widerstand zum Leistungshalbleiter räumlich beabstandet und von dessen elektrischen Potential entkoppelt. Über der Spannungsabfall am Shunt bzw. dem SMD-Widerstand lässt sich auf dessen Temperatur schließen und somit auch auf eine Temperaturbelastung des Leistungshalbleiters insgesamt. Der SMD-Widerstand liefert daher über den Spannungsabfall ein Temperatursignal und kann beispielsweise als ein NTC-Widerstand (Negative Temperature Coefficient Thermistors) ausgebildet sein, welcher seinen Widerstand in Abhängigkeit der vorliegenden Temperatur verändert. Dieser ist üblicherweise in einem Moldkörper eingebettet und weist entsprechende elektrische Anschlüsse an. Die Patentschrift DE102007020618B3 zeigt in Fig. 2 einen Schaltplan einer B6-Transistorbrückenschaltung und in Fig. 3 deren Ausführung auf einem Schaltungsträger. Auf dem Schaltungsträger ist auch ein nicht näher bezeichneter Temperatursensor angeordnet.

Nachteilig ist, dass durch die räumliche Beabstandung beispielsweise der NTC-Widerstand thermisch vom Leistungshalbleiter entkoppelt ist. Dadurch ist es ermöglicht, dass der Leistungshalbleiter bereits eine höhere Temperatur aufweist, als durch das Temperatursignal des NTC-Widerstandes zur gleichen Zeit angezeigt wird. Dies führt dazu, dass thermische Toleranzen eingeführt werden müssen, um den Leistungshalbleiter mit geringerer maximaler Chiptemperatur zu beaufschlagen. In der Konsequenz kann auf diese Weise nicht die maximale Stromtragfähigkeit des Leistungshalbleiters genutzt werden.

Zusätzlich ist von Nachteil, dass gemäß der bekannten Ausführung der Temperaturmessung man nicht eindeutig auf die thermische Vorbelastung des Leistungshalbleiters schließen kann. So kann im Betrieb des Leistungshalbleiters dieser beispielsweise mehrfach nur kurz eingeschaltet werden. Die am NTC-Widerstand sich ergebende gemittelte Temperatur kann sich dabei in gleicher Weise für den Fall ergeben, bei welchem der Leistungshalbleiter bei niedriger Leistung über einen längeren Zeitraum betrieben wird. Dies führt insgesamt zu Fehlschlüssen über das Verhalten des Leistungshalbleiters.

Aus der Patentschrift US7382000B2 ist eine Kontaktanordnung bekannt, bei welcher ein metallischer Clip zum Entwärmen eines Leistungshalbleiters auf dessen Oberseite kontaktiert ist. Ferner ist auf dem metallischen Clip ein Chip mit einer integrierten Schaltung angeordnet. Der Chip umfasst eine Ansteuerschaltung zur Spannungsregulierung des Leistungsmoduls, welches den Leistungshalbleiter enthält. Durch den metallischen Clip ist der Chip vor überhöhten Temperaturen des Leistungshalbleiters geschützt.

Aus den Offenlegungsschriften DE102006001874 A1, DE102008026541 A1 und DE102007056581 A1 sind Kontaktanordnungen umfassend zumindest einen Leistungshalbleiter und einen mit diesem verbundenen Temperatursensor bekannt. Der Temperatursensor stellt ein Temperatursignal bereit, welches für eine Stromregelung innerhalb des Leistungshalbleiters genutzt wird. Die unabhängigen Ansprüche sind gegen die DE102006001874 A1 abgegrenzt.

### Offenbarung der Erfindung

### Vorteile

Der Erfindung liegt die Aufgabe zu Grunde, Leistungshalbleiter insbesondere innerhalb eines Leistungsmodules, besser auszunutzen und einen Betrieb bei maximal zulässigen Strömen zu ermöglichen.

Diese Aufgabe wird durch eine Kontaktanordnung zumindest eines Leistungshalbleiters mit einem Schaltungsträger einer Schaltung sowie ein die Kontaktanordnung umfassendes elektronisches Leistungsmodul mit den kennzeichnenden Merkmalen der unabhängigen Ansprüche gelöst.

Die erfindungsgemäße Kontaktanordnung betrifft eine Anordnung zumindest eines Leistungshalbleiters mit einem Schaltungsträger einer Schaltung. Der zumindest eine Leistungshalbleiter weist dabei eine Oberseite und eine Unterseite auf. Auf der Oberseite und der Unterseite sind jeweils zumindest ein elektrischer Anschluss ausgebildet, welche zum elektrischen Kontaktieren des Leistungshalbleiters mit einer Schaltung vorgesehen sind. Der Leistungshalbleiter ist mit der Unterseite, bevorzugt mit dem dort vorliegenden zumindest einen elektrischen Anschluss, mit dem Schaltungsträger verbunden. Ferner ist auf der Oberseite des zumindest einen Leistungshalbleiters mittelbar oder unmittelbar ein elektrisches und/oder elektronisches Bauelement angeordnet. Dabei ist das elektrische und/oder elektronische Bauelement ein Temperatursensor, welcher ausgebildet ist, eine Temperatur des Leistungshalbleiters zu ermitteln und ein Temperatursignal bereitzustellen, welches als Regelgröße für einen maximalen Strom in dem zumindest einem Leistungshalbleiter dient. Der Temperatursensor ist vertikal zum Leistungshalbleiter auf diesem angeordnet. Dies kann unmittelbar durch eine direkte Kontaktierung von Temperatursensor und der Oberseite des Leistungshalbleiters erfolgen. Ebenso ist eine mittelbare Kontaktierung derart denkbar, indem zwischen dem Leistungshalbleiter und dem Temperatursensor schaltungstechnisch vorgesehene Bauteile und/oder Bauelemente zwischengeschaltet sind. Insbesondere ist der Temperatursensor bevorzugt über eine Verbindungsschicht unmittelbar oder mittelbar auf der Oberseite des Leistungshalbleiters angeordnet, wobei die Verbindungsschicht insbesondere eine hohe Wärmeleitfähigkeit aufweist, um den thermischen Widerstand bis zum Temperatursensor bestmöglich klein zu halten. Grundsätzlich ist damit der Temperatursensor in vorteilhafter Weise thermisch eng an den Leistungshalbleiter gekoppelt. Insbesondere können somit die Abstände zueinander so kurz gehalten werden, dass die Temperatur am Leistungshalbleiter und die Temperatur am Temperatursensor sich identisch entsprechen. Ebenso kann durch die Ausführung von einem zeitnahen Temperaturangleich zwischen Temperatursensor und dem Leistungshalbleiter ausgegangen werden. In vorteilhafter Weise kann somit jederzeit der exakte Temperaturwert des Leistungshalbleiters durch den Temperatursensor ermittelt werden. Dies hat zu Folge, dass eine reale Temperaturüberwachung des Leistungshalbleiters erfolgen kann und dieser bis kurz vor Erreichen von für den Betrieb als kritisch einzustufenden Temperaturwerten mit maximalen Strömen betrieben werden kann. Dadurch ist in Berücksichtigung der Temperatur der Leistungshalbleiter bis zu seiner maximalen Stromtragfähigkeit ausgenutzt.

Ferner weist die Kontaktanordnung zumindest ein Verbindungselement auf, welches mindestens einen Drahtbond oder ein Bondbändchen oder einen metallischen Clip umfasst. Ferner weist der Temperatursensor zumindest einen ersten und einen zweiten elektrischen Anschluss auf, welche jeweils eine Kontaktoberfläche umfassen. Zumindest eine der Kontaktoberflächen ist dabei mittelbar oder unmittelbar mit zumindest einem Verbindungselement verbunden. Das zumindest eine Verbindungselement liegt somit am gleichen elektrischen Potential an, wie der erste oder der zweite elektrische Anschluss des Temperatursensors.

Bei einer erfindungsgemäßen Ausführungsform, bei welcher die Oberseite über einen metallischen Clip elektrisch kontaktiert ist und der metallische Clip wiederum durch einen elektrischen Anschluss des Temperatursensors kontaktiert ist, ist auch das zumindest eine Verbindungselement mit dem metallischen Clip verbunden. Dadurch sind insgesamt der Leistungshalbleiter und der Temperatursensor auf dem gleichen Potential anliegend. Gleiches gilt, wenn die Oberseite des Leistungshalbleiters, insbesondere ein dort ausgebildeter elektrischer Anschluss, unmittelbar mit einem der elektrischen Anschlüsse des Temperatursensors und ebenso mit dem zumindest einen Verbindungselement elektrisch kontaktiert ist. Ferner ist es ebenso denkbar, dass der Temperatursensor auf der Oberseite des Leistungshalbleiters mittelbar oder unmittelbar angeordnet ist, ohne dass die Oberseite mit einem der elektrischen Anschlüsse des Temperatursensors elektrisch kontaktiert ist. Beispielsweise ist hierbei der erste und der zweite elektrische Anschluss auf einer Oberseite des Temperatursensors ausgebildet, welche der Oberseite des Leistungshalbleiters abgewandt ist. Dabei kann der Temperatursensor auch eine Einhäusung umfassen, welche einerseits eine mittelbare oder unmittelbare Anordnung und Verbindung mit dem Leistungshalbleiter ermöglicht und andererseits den ersten und den zweiten elektrischen Anschluss freigibt, welche bevorzugt dann jeweils mit dem oben genannten zumindest einen Verbindungselement verbunden sind.

Grundsätzlich sind in erfindungsgemäßen Ausführungsformen die Kontaktoberfläche des ersten und/oder des zweiten elektrischen Anschlusses des Temperatursensors aus Ag, einer Ag-Legierung, Au oder einer Au-Legierung gebildet. Zur Vermeidung einer Kontaktkorrosion innerhalb einer Kontaktanordnung sind verschiedene Möglichkeiten gegeben. So ist in einer erfindungsgemäßen Ausführungsform eine vorteilhafte Möglichkeit dadurch gegeben, dass die Kontaktoberfläche des ersten und/oder des zweiten elektrischen Anschlusses jeweils mit einem metallischen Clip aus Kupfer, einer Kupferlegierung, Nickel oder einer Nickellegierung verbunden ist.

Ist dagegen ein Verbindungselement in Form zumindest eines Drahtbonds oder eines Bondbändchens aus Al oder einer AL-Legierung vorgesehen, so ergibt sich eine erfindungsgemäße Ausführungsform, bei welcher zumindest eine der Kontaktoberflächen des Temperatursensors mit einer ersten Seite eines Kontaktplättchens kontaktiert ist, während eine zweite Seite des Kontaktplättchens mit dem jeweiligen zumindest einen Verbindungselement kontaktiert ist. Dabei ist das Kontaktplättchen aus Cu, einer Cu-Legierung, Ni oder einer Ni-Legierung, aus Wolfram oder aus Molybdän gebildet oder die erste und/oder die zweite Seite des Kontaktplättchens weist eine Beschichtung auf, welche aus Cu, einer Cu-Legierung, Ni oder einer Ni-Legierung gebildet ist. Als eine mögliche Cu-Legierung ist beispielsweise CuSn 0,15, CuSn6, CuFeP vorgesehen, während als Ni-Legierung NiP oder NiV vorteilhaft geeignet ist. In vorteilhafter Weise ergeben sich durch Zwischenschalten des Kontaktplättchen an dessen Verbindungsstellen mit den elektrischen Anschlüssen des Temperatursensors bzw. mit dem Verbindungselement jeweils eine neue Materialpaarung, welche weniger korrosionsanfällig ist. Der Hintergrund hierfür ist, dass die jeweiligen Materialien der neuen Materialpaarungen in ihren Elektronegativitäten einen geringeren Unterschied aufweisen. Die bevorzugt elektrische Kontaktierung des Verbindungselementes mit dem Temperatursensor erfolgt demnach mittelbar über das Kontaktplättchen, wodurch die gebildete Kontaktanordnung eine deutlich verbesserte Betriebssicherheit infolge der verbesserten Korrosionsbeständigkeit aufzeigt. Ferner ist durch das Kontaktplättchen die mechanische Beanspruchbarkeit für eine Verbindung des Temperatursensors vorteilhaft erhöht. Demnach ist der Temperatursensor und/oder dessen elektrische Anschlüsse vor mechanischen Beschädigungen besser geschützt, insbesondere bei Kontaktierungsvorgängen mit Verbindungselementen, bei welchen bekanntlich kurzzeitig hohe Kontaktierungskräfte erforderlich sind. Erfindungsgemäß können sich die Materialpaarungen aus der Kontaktierung von entsprechenden Beschichtungen ergeben, welche auf der ersten und/oder der zweiten Seite des Kontaktplättchens aufgetragen sind. Für diesen Fall kann das Grundmaterial des Kontaktplättchens auch derart gewählt werden, dass das Beschichtungsmaterial einfach und günstig durch bekannte Verfahren auf die erste und/oder zweite Seite des Kontaktplättchens aufgetragen werden kann.

Anders als die Erfindung kann auch ein Kontaktplättchen aus Al oder einer Al-Legierung vorgesehen werden. Dies ist nur dann ermöglicht, wenn das Kontaktplättchen aus Al oder einer Al-Legierung mittels eines elektrisch leitfähigen Klebers auf die zumindest eine Kontaktoberfläche aufgebracht ist und somit insgesamt von dieser galvanisch getrennt bleibt.

Alternativ weist die zweite Seite des Kontaktplättchens eine Beschichtung auf, welche aus Pd, einer Pd-Legierung, Al oder einer Al-Legierung, beispielsweise aus AlCu oder AlSi oder AlSiCu oder AlMg, aus Ag oder einer Ag-Legierung gebildet ist. In vorteilhafter Weise sind das weitere Materialien, welche eine günstige Haftgrundlage für ein Verbindungselement bei hervorragender elektrischer Leitfähigkeit zeigen. Zusätzlich ist hinsichtlich einer Verbindung mit dem zumindest einen Verbindungselement die Korrosionsanfälligkeit für die sich ergebende Kontaktanordnung sehr gering. Demnach ist es ermöglicht, die zweite Seite des Kontaktplättchens mit der genannten Beschichtung dann vorzusehen, wenn das Kontaktplättchen selbst und demnach auch dessen erste Seite aus Cu, einer Cu-Legierung, Ni oder einer Ni-Legierung, aus Wolfram oder aus Molybdän gebildet ist. Ebenso kann dies erfolgen, wenn die erste Seite ebenfalls eine Beschichtung aufweist, wobei das Kontaktplättchen außer aus Cu, einer Cu-Legierung, Ni oder einer Ni-Legierung, aus Wolfram oder aus Molybdän auch aus einem anderen Material gebildet sein kann, welches eine guten Beschichtbarkeit für die genannten Materialien der Beschichtungen für die erste und die zweite Seite des Kontaktplättchens aufweist.

Die Verwendung eines Kontaktplättchens in zuvor beschriebener Ausführung ist auch vorteilhaft, wenn die Kontaktoberfläche des ersten und/oder des zweiten elektrischen Anschlusses des Temperatursensors aus Al oder einer Al-Legierung vorgesehen ist und zusätzlich zumindest ein Drahtbond oder ein Bändchenbond aus Au, einer Au-Legierung, Ag oder einer Ag-Legierung eingesetzt wird. In diesem Fall wird als Beschichtung auf die zweite Seite des Kontaktplättchens eine Beschichtung aus Ag oder einer Ag-Legierung vorgesehen.

Bevorzugt weist das Kontaktplättchen eine Dicke in einem Bereich von 0,1 mm - 10 mm auf. Die auf der ersten und/oder zweiten Seite des Kontaktplättchens aufgebrachte Beschichtung liegt bevorzugt in einem Dickenbereich von 0,5 µm - 1000 µm. Die Beschichtungen können beispielsweise durch (Walz-) Plattieren, eine galvanische Beschichtung, ein Dünnschichtverfahren wie beispielsweise PVD oder CVD oder einem Aufdampfen, einem Spritzverfahren wie Plasmaspritzen oder Kaltgasspritzen, auf die erste und/oder zweite Seite des Kontaktplättchens aufgetragen werden.

Insgesamt ist erfindungsgemäß der Vorteil gegeben, dass durch Vorsehen des Kontaktplättchens eine oxidationsträge Oberfläche zur Kontaktierung mit einem Verbindungselement vorliegt. Folglich sind die Hafteigenschaften für ein zu kontaktierendes Verbindungselement in vorteilhafter Weise optimiert.

Durch die in den abhängigen Ansprüchen aufgeführten Maßnahmen sind vorteilhafte Weiterbildungen und Verbesserungen der erfindungsgemäßen Kontaktanordnung möglich.

Bevorzugt ist der zumindest eine Leistungshalbleiter ein Leistungs-MOSFET, ein Leistungstransistor, ein IGBT oder eine Leistungsdiode. Diese sind üblicherweise Bestandteil eines Leistungsmoduls, welches dann beispielsweise in der Funktion als Gleichrichter, Wechselrichter oder als Umrichter besonders vorteilhaft betrieben werden kann.

Eine vorteilhafte Ausführungsform sieht vor, dass der zumindest eine Leistungshalbleiter als ungehäuster Chip ausgebildet ist. Derartige Ausführungen sind beispielsweise als bare-die bekannt. Auf diese Weise kann die Temperatur des Leistungshalbleiters ungehindert und über sehr kurze Wege bis zum Temperatursensor gelangen, so dass eine Verfälschung oder eine Verzögerung einer Temperaturmessung durch den Temperatursensor vorteilhaft reduziert, wenn nicht sogar nahezu ausgeschlossen ist.

Eine bevorzugte Ausführungsform sieht vor, dass der Temperatursensor durch mindestens einen NTC (Negative Temperature Coefficient Thermistors), einen PTC (Positive Temperature Coefficient Thermistors) oder eine Diode gebildet ist. Derartige Bauelemente sind besonders gut als Temperatursensor geeignet und können insbesondere als SMD-Bauteile bezogen werden, wodurch eine sehr einfache mittelbare oder unmittelbare Anordnung auf dem Leistungshalbleiter ermöglicht ist. Zusätzlich ist von Vorteil, wenn diese für die Anordnung auf dem Leistungshalbleiter insbesondere ungehäust ausgeführt sind. Nach der Anordnung können sie durch beispielsweise eine Moldmasse verschlossen werden.

Auf diese Weise ist eine Temperaturangleichung an die Temperatur des Leistungshalbleiters besonders günstig gegeben.

Weiterhin ergibt sich eine vorteilhafte Ausführungsform, bei welcher die Oberseite des zumindest einen Leistungshalbleiters mit einem metallischen Clip elektrisch kontaktiert ist und der Temperatursensor auf dem metallischen Clip in unmittelbarer Nähe zur Oberseite des zumindest einen Leistungshalbleiter angeordnet ist. Dadurch ist der Vorteil gegeben, dass der Leistungshalbleiter über den metallischen Clip wirkungsvoll entwärmt werden kann. Auf diese Weise können im Vergleich zu einer Ausführung ohne zusätzlicher Entwärmung des Leistungshalbleiters dieser bis zur Erreichung einer gleichen Temperatur mit höheren Strömen angesteuert bzw. geregelt werden. Zeitgleich gewährt der metallische Clip durch seine günstige thermische Leitfähigkeit weiterhin einen nahezu ungehinderten Temperaturübertrag auf den Temperatursensor. Darüber hinaus wird durch den metallischen Clip eine räumliche und zeitliche Ausgleichsstreuung der Temperatur des Leistungshalbleiters bewirkt, wodurch sich ausgehend vom Temperatursensor insgesamt eine günstigere Signaldynamik zur Ausregelung beziehungsweise Begrenzung der maximalen Ströme für den Leistungshalbleiter ergibt. Bevorzugt ist der metallische Clip aus Kupfer oder einer Kupferlegierung gebildet. Dieser lässt sich in einfacher Weise mit der Oberseite des Leistungshalbleiters verbinden, bzw. mit einem dort ausgebildeten elektrischen Anschluss kontaktiert, beispielsweise durch eine Lot-, Sinter- oder Kleberschicht.

In einer günstigen Ausführungsform ist der metallische Clip als Brücke ausgebildet, welche den zumindest einen Leistungshalbleiter mit mindestens einem weiteren Leistungshalbleiter elektrisch verbindet. Auf diese Weise können verschiedene Schaltungstopologien, beispielsweise in Form einer Brückenschaltung, für ein Leistungsmodul als Gleichrichter, Wechselrichter oder Umrichter realisiert werden. Die Brücke verbindet beispielsweise elektrische Anschlüsse gleich mehrerer Leistungshalbleiter mit dem gleichen elektrischen Potential.

In Weiterbildung dieser Ausführungsform mit dem metallischen Clip als Brücke ist für besondere Anwendungsvorgaben auch eine elektrische Isolation zwischen dem auf der Brücke angeordneten Temperatursensor und dem Leistungshalbleiter denkbar. Hierzu weist der metallische Clip als Brücke eine Isolationsschicht auf. Die Isolationsschicht kann beispielsweise aus einem elektrisch isolierenden Kunststoff oder durch eine Keramik ausgebildet sein. Besonders einfach ist eine Realisierung dadurch möglich, indem die Brücke als ein DBC (direct-bondedcopper) oder ein IMS (insulated-metal-substrat) vorgesehen wird. Hierbei wird in vorteilhafter Weise der Temperatursensor bereits durch das im DBC oder IMS enthaltende Isolationsmaterial elektrisch zum Leistungshalbleiter entkoppelt.

Bevorzugt ist eine Ausführungsform, bei welcher der Temperatursensor auf dem gleichen elektrischen Potential, insbesondere im Hochspannungskreis, anliegt, wie der zumindest eine Leistungshalbleiter. Hierfür weist der Temperatursensor zumindest einen ersten und einen zweiten elektrischen Anschluss auf, welche jeweils eine Kontaktoberfläche umfassen. Dabei ist zumindest eine der Kontaktoberflächen mittelbar oder unmittelbar mit der Oberseite des Leistungshalbleiters elektrisch kontaktiert.

Grundsätzlich ist erfindungsgemäß das Temperatursignal gebildet durch einen Spannungsabfall am Temperatursensor. Der Spannungsabfall ist als Spannungsdifferenz zwischen dem elektrischen Potential des ersten und dem elektrischen Potential des zweiten elektrischen Anschlusses messbar.

Die Erfindung betrifft auch ein elektronisches Leistungsmodul, insbesondere einen Gleichrichter, einen Wechselrichter oder einen Umrichter, umfassend die zuvor beschriebene erfindungsgemäße Kontaktanordnung. Bevorzugt weist das elektronische Leistungsmodul elektrische Außenkontakte auf, insbesondere als Signalpins. Dabei ist mindestens ein erster Außenkontakt mit dem Drahtbond, dem Bondbändchen oder dem metallischen Clip verbunden, welcher die Kontaktoberfläche des ersten oder des zweiten elektrischen Anschlusses des Temperatursensors mittelbar oder unmittelbar kontaktiert. Ferner ist mindestens ein zweiter Außenkontakt mit dem Drahtbond, dem Drahtbändchen oder dem metallischen Clip verbunden, welcher die Kontaktoberfläche des anderen elektrischen Anschlusses des Temperatursensors mittelbar oder unmittelbar kontaktiert. Hierbei ist der Spannungsabfall dann am Temperatursensor über die Spannungsdifferenz zwischen dem ersten und dem zweiten Außenkontakt als Temperatursignal abgreifbar. In vorteilhafter Weise ist der Temperatursensor somit in einer besonders günstigen Weise im Leistungsmodul integriert und eine Berücksichtigung des Temperatursignals durch entsprechende Verdrahtung des Leistungsmodules in einer Schaltung gewährleistet.

Das Leistungsmodul weist in einer besonders günstigen Ausführungsform eine Einhäusung auf, welche bevorzugt aus einer Moldmasse gebildet ist.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnung. Diese zeigt in:
- Fig. 1:: ein Ausführungsbeispiel einer erfindungsgemäßen Kontaktanordnung eines Temperatursensors und eines Verbindungselementes in einer Seitenschnittdarstellung,
- Fig. 2:: ein erfindungsgemäßes Leistungsmodul in einer Draufsicht.

### Ausführungsformen der Erfindung

In den Figuren sind funktional gleiche Bauteile jeweils mit gleichen Bezugszeichen gekennzeichnet.

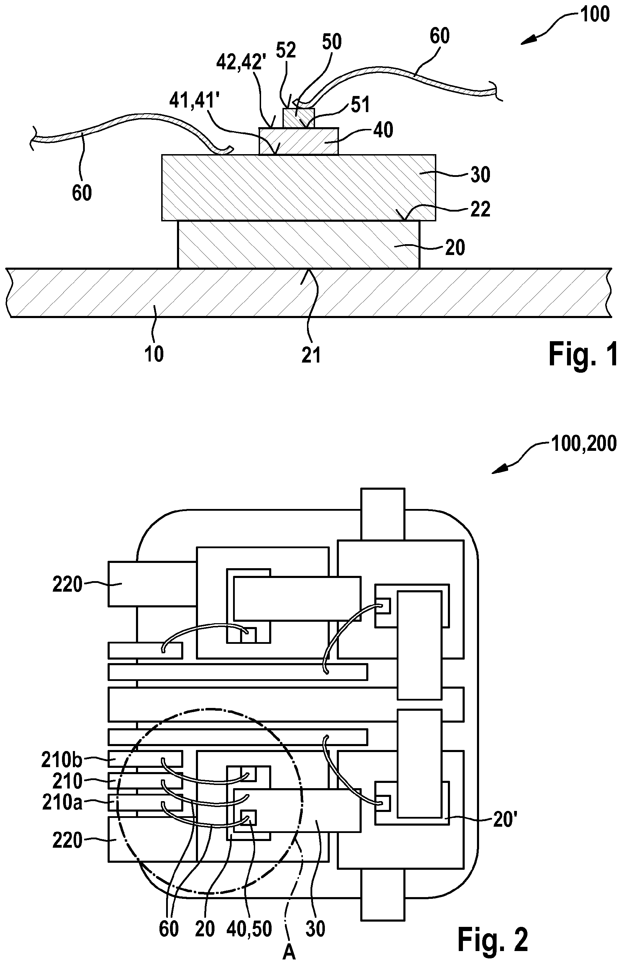

In Fig. 1 ist ein Ausführungsbeispiel einer erfindungsgemäßen Kontaktanordnung 100 gezeigt. Dabei ist auf einem Schaltungsträger 10, beispielsweise einem Stanzgitter oder einem PCB (printed circuit board), ein Leistungshalbleiter 20 angeordnet. Als Leistungshalbleiter 20 kann beispielsweise ein Leistungs-MOSFET oder ein IGBT oder ein Leistungstransistor vorgesehen sein. Der Leistungshalbleiter 20 weist eine Unterseite 21 und eine Oberseite 22 auf. Der Leistungshalbleiter 20 weist ebenso auf seiner Unterseite 21 und auf seiner Oberseite 22 jeweils zumindest einen elektrischen Anschluss (nicht dargestellt) auf. Über den elektrischen Anschluss auf der Unterseite 21 ist der Leistungshalbleiter 20 beispielsweise mit Leiterbahnen und/oder einer auf dem Schaltungsträger 10 ausgebildeten Schaltung insgesamt verbunden. Über die Oberseite 22 ist mittelbar ein weiteres elektrisches und/oder elektronisches Bauelement 40 vertikal über dem Leistungshalbleiter 20 angeordnet. Als elektrisches und/oder elektronisches Bauelement ist ein Temperatursensor 40 vorgesehen, bevorzugt als ein NTC-Bauteil. Zwischen dem Temperatursensor 40 und dem Leistungshalbleiter 20 ist ein metallischer Clip 30, insbesondere aus Cu oder einer Cu-Legierung, vorgesehen, welcher die Oberseite 22, insbesondere den dort vorliegenden elektrischen Kontakt des Leistungshalbleiters 20, elektrisch kontaktiert, beispielsweise mittels einer Lot-, Sinter- oder Kleberschicht. Der Temperatursensor 40 weist ebenso eine Oberseite und eine Unterseite auf, wobei auf der Unterseite zumindest in einem Bereich ein erster elektrischer Anschluss 41 und auf der Oberseite zumindest in einem Bereich ein zweiter elektrischer Anschluss 42 des Temperatursensors 40 ausgebildet ist. Die elektrischen Anschlüsse 41, 42 umfassen jeweils eine Kontaktoberfläche 41', 42' zum mittelbaren oder unmittelbaren Kontaktieren des Temperatursensors 40 mit beispielsweise der Schaltung auf dem Schaltungsträger 10. Die Kontaktoberflächen 41', 42' sind insbesondere aus Ag, einer Ag-Legierung, Au oder einer Au-Legierung, beispielsweise in Form einer auf die elektrischen Anschlüsse 41, 42 aufgebrachten Metallisierung gebildet. Der Temperatursensor 40 ist über seinen ersten elektrischen Kontakt 41 mittels der Kontaktoberfläche 41' mit dem metallischen Clip 30 elektrisch kontaktiert. Auf diese Weise liegt der Temperatursensor 40 auf dem gleichen elektrischen Potential an, insbesondere im Hochspannungskreis, wie der Leistungshalbleiter 20. Ferner ist der Temperatursensor 40 insgesamt in dieser Ausführung in unmittelbarer Nähe zur Oberseite 22 des Leistungshalbleiters 20 angeordnet. Der Temperatursensor 40 ist ausgebildet, eine Temperatur des Leistungshalbleiters 20 zu ermitteln und ein Temperatursignal bereitzustellen, welches als Regelgröße für einen maximalen Strom in dem zumindest einem Leistungshalbleiter 20 dient. Über die Kontaktoberfläche 42' des zweiten elektrischen Anschlusses 42 des Temperatursensors 40 ist zusätzlich eine erste Seite 51 eines Kontaktplättchens 50 kontaktiert, beispielsweise mittels einer Lot-, Sinter- oder Kleberschicht. Das Kontaktplättchen 50 ist aus Cu, einer Cu-Legierung, Ni oder einer Ni-Legierung, Wolfram oder Molybdän gebildet. Auf einer zweiten Seite 52 des Kontaktplättchen 50 ist optional noch eine Beschichtung aus Al, einer Al-Legierung, Pd oder einer Pd-Legierung aufgetragen. Die zweite Seite 52 des Kontaktplättchen 50 ist mit einem Verbindungselement 60, insbesondere mit zumindest einem Drahtbond oder einem Bändchenbond aus Al oder einer Al-Legierung, kontaktiert. Ebenso ist der metallische Clip 30 mit zumindest einem oben genannten Verbindungselement 60 kontaktiert. Die Kontaktanordnung 100 ist beispielsweise Teil eines Leistungsmodules 200, welches in einer Draufsicht in der Fig. 2 dargestellt ist. Das Leistungsmodul 200 ist beispielsweise als Gleichrichter, Wechselrichter oder Umrichter ausgebildet und umfasst hierfür eine Brückenschaltung (nicht separat gezeigt). Neben dem oben genannten Leistungshalbleiter 20 sind noch weitere Leistungshalbleiter 20' innerhalb des Leistungsmoduls 200 enthalten, insbesondere in Ausbildung einer Brückenschaltung. Denkbar sind Ausführungsformen eines Leistungsmodules 200, welchem der metallische Clip 30 in Form einer Brücke ausgebildet ist, welche den Leistungshalbleiter 20, auf welchem der Temperatursensor 40 angeordnet ist, mit zumindest einem weiteren Leistungshalbleiter 20' verbindet. Das Leistungsmodul 200 umfasst ferner noch elektrische Außenkontakte 210, 220, welche beispielsweise als Signalpins 210 oder als Anschlüsse 220 für die Spannungsversorgung und Ansteuerung des Leistungsmoduls 200 ausgebildet sind. Der Ausschnitt A zeigt den Bereich des Leistungsmodules 200 in welchem der Temperatursensor 40 mittelbar über den metallischen Clip 30 mit der Oberseite 22 des Leistungshalbleiters 20 entsprechend der erfindungsgemäßen Kontaktanordnung 100 kontaktiert ist. Ferner ist das Kontaktplättchen 50 erkennbar, welches mit seiner ersten Seite 51 mit der Kontaktoberfläche 42' des zweiten elektrischen Anschlusses 42 des Temperatursensors 40 kontaktiert ist. Die zweite Seite 52 des Kontaktplättchens 50 ist dagegen mit dem einen Ende des Verbindungselementes 60, insbesondere einem Drahtbond oder einem Bändchenbond, kontaktiert. Das andere Ende des Verbindungselementes 60 ist wiederum mit einem Außenkontakt des Leistungsmodules 200, beispielsweise einem Signalpin 210a, verbunden. Das eine Verbindungselement 60, welchem mit seinem einen Ende am metallischen Clip 30 verbunden ist und somit am gleichen Potential anliegt, wie der erste elektrische Anschluss 41 des Temperatursensors 40, ist mit seinem anderen Ende ebenfalls mit einem Außenkontakt des Leistungsmodules 200, beispielsweise einem Signalpin 210b, verbunden. Über die Spannungsdifferenz zwischen den beiden Signalpins 210a, 210b ist dann der Spannungsabfall am Temperatursensor 40 als Temperatursignal abgreifbar. Das Ausführungsbeispiel gemäß den Fig. 1 und 2 kann entsprechend der beschriebenen Weiterbildungen oder Variationen für eine erfindungsgemäße Kontaktanordnung 100 bzw. ein die Kontaktanordnung 100 umfassendes Leistungsmodul 200 verändert ausgeführt sein.

## Patentansprüche

1. Kontaktanordnung (100) zumindest eines Leistungshalbleiters (20) mit einem Schaltungsträger (10) einer Schaltung, wobei der zumindest eine Leistungshalbleiter (20) eine Oberseite (22) und eine Unterseite (21) aufweist und mit der Unterseite (21) mit dem Schaltungsträger (10) verbunden ist, und wobei auf der Oberseite (22) des zumindest einen Leistungshalbleiters (20) mittelbar oder unmittelbar ein elektrisches und/oder elektronisches Bauelement (40) angeordnet ist, und das elektrische und/oder elektronische Bauelement ein Temperatursensor (40) ist, welcher ausgebildet ist, eine Temperatur des Leistungshalbleiters (20) zu ermitteln und ein Temperatursignal bereitzustellen, welches als Regelgröße für einen maximalen Strom in dem zumindest einem Leistungshalbleiter (20) dient, wobei der Temperatursensor (40) zumindest einen ersten und einen zweiten elektrischen Anschluss (41, 42) aufweist und diese jeweils eine Kontaktoberfläche (41', 42') umfassen, und dass die Kontaktanordnung (100) zumindest ein Verbindungselement (60) aufweist, welches mindestens einen Drahtbond oder ein Bondbändchen oder einen metallischen Clip umfasst, welche jeweils mit der Kontaktoberfläche (41', 42') des ersten oder des zweiten elektrischen Anschlusses (41, 42) des Temperatursensors (40) mittelbar oder unmittelbar verbunden ist und somit am gleichen elektrischen Potential anliegt, wie der erste oder der zweite elektrische Anschluss (41, 42) des Temperatursensors (40),
**dadurch gekennzeichnet, dass**
die Kontaktoberfläche (41', 42') des ersten und/oder des zweiten elektrischen Anschlusses (41, 42) aus Ag, einer Ag-Legierung, Au oder einer Au-Legierung gebildet ist und zur Vermeidung einer Kontaktkorrosion mit einem metallischen Clip aus Kupfer, einer Kupferlegierung, Nickel oder einer Nickellegierung verbunden ist.

2. Kontaktanordnung (100) zumindest eines Leistungshalbleiters (20) mit einem Schaltungsträger (10) einer Schaltung, wobei der zumindest eine Leistungshalbleiter (20) eine Oberseite (22) und eine Unterseite (21) aufweist und mit der Unterseite (21) mit dem Schaltungsträger (10) verbunden ist, und wobei auf der Oberseite (22) des zumindest einen Leistungshalbleiters (20) mittelbar oder unmittelbar ein elektrisches und/oder elektronisches Bauelement (40) angeordnet ist, und das elektrische und/oder elektronische Bauelement ein Temperatursensor (40) ist, welcher ausgebildet ist, eine Temperatur des Leistungshalbleiters (20) zu ermitteln und ein Temperatursignal bereitzustellen, welches als Regelgröße für einen maximalen Strom in dem zumindest einem Leistungshalbleiter (20) dient, wobei der Temperatursensor (40) zumindest einen ersten und einen zweiten elektrischen Anschluss (41, 42) aufweist und diese jeweils eine Kontaktoberfläche (41', 42') umfassen, und dass die Kontaktanordnung (100) zumindest ein Verbindungselement (60) aufweist, welches mindestens einen Drahtbond oder ein Bondbändchen oder einen metallischen Clip umfasst, welche jeweils mit der Kontaktoberfläche (41', 42') des ersten oder des zweiten elektrischen Anschlusses (41, 42) des Temperatursensors (40) mittelbar oder unmittelbar verbunden ist und somit am gleichen elektrischen Potential anliegt, wie der erste oder der zweite elektrische Anschluss (41, 42) des Temperatursensors (40),
**dadurch gekennzeichnet, dass**
die Kontaktoberfläche (41', 42') des ersten und/oder des zweiten elektrischen Anschlusses (41, 42) aus Ag, einer Ag-Legierung, Au oder einer Au-Legierung und der Drahtbond oder das Bondbändchen aus Al oder einer AL-Legierung gebildet ist oder die Kontaktoberfläche (41', 42') des ersten und/oder des zweiten elektrischen Anschlusses (41, 42) aus Al oder einer Al-Legierung und der Drahtbond oder das Bondbändchen aus Au, einer Au-Legierung, aus Ag oder einer Ag-Legierung gebildet ist, und die Kontaktoberfläche (41', 42') des ersten und/oder des zweiten elektrischen Anschlusses (41, 42) zur Vermeidung einer Kontaktkorrosion mit einer ersten Seite (51) eines Kontaktplättchen (50) verbunden ist, während eine zweite Seite des Kontaktplättchen mit dem jeweiligen zumindest einen Verbindungselement kontaktiert ist, wobei das Kontaktplättchen aus Cu, einer Cu-Legierung, Ni oder einer Ni-Legierung, aus Wolfram oder aus Molybdän gebildet ist oder die erste und/oder die zweite Seite des Kontaktplättchen eine Beschichtung aufweist, welche aus Cu, einer Cu-Legierung, Ni oder einer Ni-Legierung gebildet ist.

3. Kontaktanordnung (100) nach Anspruch 1 oder 2,
**dadurch gekennzeichnet, dass**
der zumindest eine Leistungshalbleiter (20) ein Leistungs-MOSFET, ein Leistungstransistor, ein IGBT oder eine Leistungsdiode ist.

4. Kontaktanordnung (100) nach einem der vorhergehenden Ansprüche,
**dadurch gekennzeichnet, dass**
der zumindest eine Leistungshalbleiter (20) als ungehäuster Chip ausgebildet ist.

5. Kontaktanordnung (100) nach einem der vorhergehenden Ansprüche,
**dadurch gekennzeichnet, dass**
der Temperatursensor (40) durch mindestens einen NTC, einen PTC oder eine Diode gebildet ist.

6. Kontaktanordnung (100) nach einem der Ansprüche 1 oder 3 bis 5,
**dadurch gekennzeichnet, dass**
die Oberseite (22) des zumindest einen Leistungshalbleiters (20) mit dem metallischen Clip (30) elektrisch kontaktiert ist und der Temperatursensor (40) auf dem metallischen Clip (30) in unmittelbarer Nähe zur Oberseite (22) des zumindest einen Leistungshalbleiter (20) angeordnet ist.

7. Kontaktanordnung (100) nach einem der Ansprüche 1 oder 3 bis 6,
**dadurch gekennzeichnet, dass**
der metallische Clip als Brücke (30) ausgebildet ist, welche den zumindest einen Leistungshalbleiter (20) mit mindestens einem weiteren Leistungshalbleiter (20') elektrisch verbindet.

8. Kontaktanordnung (100) nach Anspruch 7,
**dadurch gekennzeichnet, dass**
zur elektrischen Isolation zwischen dem Temperatursensor (40) und den Leistungshalbleitern (20, 20') der metallische Clip als Brücke (30) eine Isolationsschicht aufweist.

9. Kontaktanordnung (100) nach Anspruch 8,
**dadurch gekennzeichnet, dass**
die Isolationsschicht als DBC oder als IMS ausgebildet ist.

10. Kontaktanordnung (100) nach einem der vorhergehenden Ansprüche,
**dadurch gekennzeichnet, dass**
der Temperatursensor (40) auf dem gleichen elektrischen Potential wie der zumindest eine Leistungshalbleiter (20) anliegt, indem einer der Kontaktoberflächen (41', 42') mittelbar oder unmittelbar mit der Oberseite (22) des Leistungshalbleiters (20) elektrisch kontaktiert ist.

11. Kontaktanordnung (100) nach einem der vorhergehenden Ansprüche,
**dadurch gekennzeichnet, dass**
das Temperatursignal gebildet ist durch einen Spannungsabfall am Temperatursensor (40) und der Spannungsabfall als Spannungsdifferenz zwischen dem elektrischen Potential des ersten und dem elektrischen Potential des zweiten elektrischen Anschlusses (41, 42) messbar ist.

12. Elektronisches Leistungsmodul (200), umfassend eine Kontaktanordnung (100) nach einem der Ansprüche 1 bis 11.

13. Elektronisches Leistungsmodul (200) nach Anspruch 12, wobei das elektronische Leistungsmodul (200) ein Gleichrichter, ein Wechselrichter oder ein Umrichter ist.

14. Elektronisches Leistungsmodul (200) nach Anspruch 12 oder 13,
**dadurch gekennzeichnet, dass**
das elektronische Leistungsmodul (200) elektrische Außenkontakte (210, 220) aufweist, wobei mindestens ein erster Außenkontakt (210a) mit dem Drahtbond, dem Bondbändchen oder dem metallischen Clip (60) verbunden ist, welcher die Kotaktoberfläche (41', 42') des ersten oder des zweiten elektrischen Anschlusses (41, 42) des Temperatursensors (40) mittelbar oder unmittelbar kontaktiert und wobei mindestens ein zweiter Außenkontakt (210b) mit dem Drahtbond, dem Drahtbändchen oder dem metallischen Clip (60) verbunden ist, welcher die Kotaktoberfläche (41', 42') des anderen elektrischen Anschlusses (41, 42) des Temperatursensors (40) mittelbar oder unmittelbar kontaktiert, sodass der Spannungsabfall am Temperatursensor (40) über die Spannungsdifferenz zwischen dem ersten und dem zweiten Außenkontakt (210, 220) als Temperatursignal abgreifbar ist.

15. Elektronisches Leistungsmodul (200) nach einem der Ansprüche 12 bis 14,
**dadurch gekennzeichnet, dass**
die elektrischen Außenkontakte (210, 220) als Signalpins ausgebildet sind.

## Claims

1. Contact arrangement (100) of at least one power semiconductor (20) with a circuit carrier (10) of a circuit, wherein the at least one power semiconductor (20) has a top side (22) and a bottom side (21) and is connected to the circuit carrier (10) by way of the bottom side (21), and wherein an electrical and/or electronic component (40) is arranged indirectly or directly on the top side (22) of the at least one power semiconductor (20), and the electrical and/or electronic component is a temperature sensor (40) that is designed to ascertain a temperature of the power semiconductor (20) and to provide a temperature signal that serves as control variable for a maximum current in the at least one power semiconductor (20), wherein the temperature sensor (40) has at least a first and a second electrical connection (41, 42) and these comprise a respective contact surface (41', 42'), and the contact arrangement (100) has at least one connecting element (60) that comprises at least one wire bond or one bonding strip or one metal clip that is connected indirectly or directly in each case to the contact surface (41', 42') of the first or the second electrical connection (41, 42) of the temperature sensor (40) and is thus at the same electrical potential as the first or the second electrical connection (41, 42) of the temperature sensor (40),
**characterized in that**
the contact surface (41', 42') of the first and/or the second electrical connection (41, 42) is formed from Ag, an Ag alloy, Au or an Au alloy, and, in order to avoid contact corrosion, is connected to a metal clip made of copper, a copper alloy, nickel or a nickel alloy.

2. Contact arrangement (100) of at least one power semiconductor (20) with a circuit carrier (10) of a circuit, wherein the at least one power semiconductor (20) has a top side (22) and a bottom side (21) and is connected to the circuit carrier (10) by way of the bottom side (21), and wherein an electrical and/or electronic component (40) is arranged indirectly or directly on the top side (22) of the at least one power semiconductor (20), and the electrical and/or electronic component is a temperature sensor (40) that is designed to ascertain a temperature of the power semiconductor (20) and to provide a temperature signal that serves as control variable for a maximum current in the at least one power semiconductor (20), wherein the temperature sensor (40) has at least a first and a second electrical connection (41, 42) and these comprise a respective contact surface (41', 42'), and the contact arrangement (100) has at least one connecting element (60) that comprises at least one wire bond or one bonding strip or one metal clip that is connected indirectly or directly in each case to the contact surface (41', 42') of the first or the second electrical connection (41, 42) of the temperature sensor (40) and is thus at the same electrical potential as the first or the second electrical connection (41, 42) of the temperature sensor (40),
**characterized in that**
the contact surface (41', 42') of the first and/or the second electrical connection (41, 42) is formed from Ag, an Ag alloy, Au or an Au alloy and the wire bond or the bonding strip is formed from Al or an Al alloy or the contact surface (41', 42') of the first and/or the second electrical connection (41, 42) is formed from Al or an Al alloy and the wire bond or the bonding strip is formed from Au, an Au alloy, from Ag or an Ag alloy, and the contact surface (41', 42') of the first and/or the second electrical connection (41, 42), in order to avoid contact corrosion, is connected to a first side (51) of a contact plate (50), while a second side of the contact plate is in contact with the respective at least one connecting element, wherein the contact plate is formed from Cu, a Cu alloy, Ni or an Ni alloy, from tungsten or from molybdenum or the first and/or the second side of the contact plate has a coating that is formed from Cu, a Cu alloy, Ni or an Ni alloy.

3. Contact arrangement (100) according to Claim 1 or 2,
**characterized in that**
the at least one power semiconductor (20) is a power MOSFET, a power transistor, an IGBT or a power diode.

4. Contact arrangement (100) according to one of the preceding claims,
**characterized in that**
the at least one power semiconductor (20) is designed as an unhoused chip.

5. Contact arrangement (100) according to one of the preceding claims,
**characterized in that**
the temperature sensor (40) is formed by at least one NTC, one PTC or one diode.

6. Contact arrangement (100) according to one of Claims 1 or 3 to 5,
**characterized in that**
the top side (22) of the at least one power semiconductor (20) is in electrical contact with the metal clip (30) and the temperature sensor (40) is arranged on the metal clip (30) in the immediate proximity of the top side (22) of the at least one power semiconductor (20).

7. Contact arrangement (100) according to one of Claims 1 or 3 to 6,
**characterized in that**
the metal clip is designed as a bridge (30) that electrically connects the at least one power semiconductor (20) to at least one further power semiconductor (20').

8. Contact arrangement (100) according to Claim 7,
**characterized in that**
the metal clip in the form of a bridge (30) has an insulating layer to ensure electrical insulation between the temperature sensor (40) and the power semiconductors (20, 20').

9. Contact arrangement (100) according to Claim 8,
**characterized in that**
the insulating layer is designed as a DBC or as an IMS.

10. Contact arrangement (100) according to one of the preceding claims,
**characterized in that**
the temperature sensor (40) is at the same electrical potential as the at least one power semiconductor (20) by virtue of one of the contact surfaces (41', 42') being in indirect or direct electrical contact with the top side (22) of the power semiconductor (20).

11. Contact arrangement (100) according to one of the preceding claims,
**characterized in that**
the temperature signal is formed by a voltage drop across the temperature sensor (40) and the voltage drop is able to be measured as a voltage difference between the electrical potential of the first and the electrical potential of the second electrical connection (41, 42).

12. Electronic power module (200), comprising a contact arrangement (100) according to one of Claims 1 to 11.

13. Electronic power module (200) according to Claim 12, wherein the electronic power module (200) is a rectifier, an inverter or a converter.

14. Electronic power module (200) according to Claim 12 or 13,
**characterized in that**
the electronic power module (200) has external electrical contacts (210, 220), wherein at least one first external contact (210a) is connected to the wire bond, the bonding strip or the metal clip (60) that is in indirect or direct contact with the contact surface (41', 42') of the first or the second electrical connection (41, 42) of the temperature sensor (40), and wherein at least one second external contact (210b) is connected to the wire bond, the wire strip or the metal clip (60) that is in indirect or direct contact with the contact surface (41', 42') of the other electrical connection (41, 42) of the temperature sensor (40), such that the voltage drop across the temperature sensor (40) is able to be tapped off in the form of a temperature signal by way of the voltage difference between the first and the second external contact (210, 220).

15. Electronic power module (200) according to one of Claims 12 to 14,
**characterized in that**
the external electrical contacts (210, 220) are designed as signal pins.

## Revendications

1. Arrangement de contact (100) d'au moins un semiconducteur de puissance (20) comprenant un porte-circuit (10) d'un circuit, l'au moins un semiconducteur de puissance (20) possédant un côté supérieur (22) et un côté inférieur (21) et étant relié au porte-circuit (10) par le côté inférieur (21), et un composant (40) électrique et/ou électronique étant disposé directement ou indirectement sur le côté supérieur (22) de l'au moins un semiconducteur de puissance (20), et le composant électrique et/ou électronique étant un capteur de température (40), qui est configuré pour déterminer une température du semiconducteur de puissance (20) et fournir un signal de température, lequel sert de grandeur de régulation pour un courant maximal dans l'au moins un semiconducteur de puissance (20), le capteur de température (40) possédant au moins une première et une deuxième borne électrique (41, 42) et celles-ci comportant respectivement une surface de contact (41', 42'), et l'arrangement de contact (100) possédant au moins un élément de liaison (60), lequel comporte au moins une connexion par fil ou un ruban de connexion ou une agrafe métallique, qui est respectivement relié(e) directement ou indirectement à la surface de contact (41', 42') de la première ou de la deuxième borne électrique (41, 42) du capteur de température (40) et se trouve ainsi au même potentiel électrique que la première ou la deuxième borne électrique (41, 42) du capteur de température (40),
**caractérisé en ce que**
la surface de contact (41', 42') de la première et/ou de la deuxième borne électrique (41, 42) est constituée d'Ag, d'un alliage d'Ag, d'Au ou d'un alliage d'Au et, en vue d'éviter une corrosion de contact, est reliée à une agrafe métallique en cuivre, un alliage de cuivre, en nickel ou un alliage de nickel.

2. Arrangement de contact (100) d'au moins un semiconducteur de puissance (20) comprenant un porte-circuit (10) d'un circuit, l'au moins un semiconducteur de puissance (20) possédant un côté supérieur (22) et un côté inférieur (21) et étant relié au porte-circuit (10) par le côté inférieur (21), et un composant (40) électrique et/ou électronique étant disposé directement ou indirectement sur le côté supérieur (22) de l'au moins un semiconducteur de puissance (20), et le composant électrique et/ou électronique étant un capteur de température (40), qui est configuré pour déterminer une température du semiconducteur de puissance (20) et fournir un signal de température, lequel sert de grandeur de régulation pour un courant maximal dans l'au moins un semiconducteur de puissance (20), le capteur de température (40) possédant au moins une première et une deuxième borne électrique (41, 42) et celles-ci comportant respectivement une surface de contact (41', 42'), et l'arrangement de contact (100) possédant au moins un élément de liaison (60), lequel comporte au moins une connexion par fil ou un ruban de connexion ou une agrafe métallique, qui est respectivement relié(e) directement ou indirectement à la surface de contact (41', 42') de la première ou de la deuxième borne électrique (41, 42) du capteur de température (40) et se trouve ainsi au même potentiel électrique que la première ou la deuxième borne électrique (41, 42) du capteur de température (40),
**caractérisé en ce que**
la surface de contact (41', 42') de la première et/ou de la deuxième borne électrique (41, 42) est constituée d'Ag, d'un alliage d'Ag, d'Au ou d'un alliage d'Au et la connexion par fil ou le ruban de connexion est constitué(e) d'Al ou d'un alliage d'Al ou la surface de contact (41', 42') de la première et/ou de la deuxième borne électrique (41, 42) est constituée d'Al ou d'un alliage d'Al et la connexion par fil ou le ruban de connexion est constitué(e) d'Au, d'un alliage d'Au, d'Ag ou d'un alliage d'Ag, et la surface de contact (41', 42') de la première et/ou de la deuxième borne électrique (41, 42), en vue d'éviter une corrosion de contact, est reliée à un premier côté (51) d'une plaquette de contact (50), alors qu'un deuxième côté de la plaquette de contact est mise en contact avec l'au moins un élément de liaison respectif, la plaquette de contact étant constituée de Cu, d'un alliage de Cu, de Ni ou d'un alliage de Ni, de tungstène ou de molybdène ou le premier et/ou le deuxième côté de la plaquette de contact possédant un revêtement qui est constitué de Cu, d'un alliage de Cu, de Ni ou d'un alliage de Ni.

3. Arrangement de contact (100) selon la revendication 1 ou 2, **caractérisé en ce que** l'au moins un semiconducteur de puissance (20) est un MOSFET de puissance, un transistor de puissance, un IGBT ou une diode de puissance.

4. Arrangement de contact (100) selon l'une quelconque des revendications précédentes, **caractérisé en ce que** l'au moins un semiconducteur de puissance (20) est réalisé sous la forme d'une puce sans boîtier.

5. Arrangement de contact (100) selon l'une quelconque des revendications précédentes, **caractérisé en ce que** le capteur de température (40) est formé par au moins une CTN, une CTP ou une diode.

6. Arrangement de contact (100) selon l'une quelconque des revendications 1 ou 3 à 5, **caractérisé en ce que** le côté supérieur (22) de l'au moins un semiconducteur de puissance (20) est mis en contact électrique avec l'agrafe métallique (30) et le capteur de température (40) est disposé sur l'agrafe métallique (30) à proximité immédiate du côté supérieur (22) de l'au moins un semiconducteur de puissance (20).

7. Arrangement de contact (100) selon l'une quelconque des revendications 1 ou 3 à 6, **caractérisé en ce que** l'agrafe métallique est réalisée sous la forme d'un pont (30), lequel relie électriquement l'au moins un semiconducteur de puissance (20) à au moins un semiconducteur de puissance supplémentaire (20').

8. Arrangement de contact (100) selon la revendication 7, **caractérisé en ce que** l'agrafe métallique sous la forme d'un pont (30) possède une couche isolante servant à réaliser l'isolation électrique entre le capteur de température (40) et les semiconducteurs de puissance (20, 20').

9. Arrangement de contact (100) selon la revendication 8, **caractérisé en ce que** la couche isolante est réalisée sous la forme d'un DBC ou d'un IMS.

10. Arrangement de contact (100) selon l'une quelconque des revendications précédentes, **caractérisé en ce que** le capteur de température (40) se trouve au même potentiel électrique que l'au moins un semiconducteur de puissance (20) par le fait que l'une des surfaces de contact (41', 42') est mise en contact électrique directement ou indirectement avec le côté supérieur (22) du semiconducteur de puissance (20).

11. Arrangement de contact (100) selon l'une quelconque des revendications précédentes, **caractérisé en ce que** le signal de température est formé par une chute de tension au niveau du capteur de température (40) et la chute de tension peut être mesurée en tant que différence de tension entre le potentiel électrique de la première et le potentiel électrique de la deuxième borne électrique (41, 42).

12. Module de puissance électronique (200), comprenant un arrangement de contact (100) selon l'une quelconque des revendications 1 à 11.

13. Module de puissance électronique (200) selon la revendication 12, le module de puissance électronique (200) étant un redresseur, un onduleur ou un convertisseur.

14. Module de puissance électronique (200) selon la revendication 12 ou 13, **caractérisé en ce que** le module de puissance électronique (200) possède des contacts externes (210, 220) électriques, au moins un premier contact externe (210a) étant relié à la connexion par fil, au ruban de connexion ou à l'agrafe métallique (60), qui est en contact directement ou indirectement avec la surface de contact (41', 42') de la première ou de la deuxième borne électrique (41, 42) du capteur de température (40), et au moins un deuxième contact externe (210b) étant relié à la connexion par fil, au ruban de connexion ou à l'agrafe métallique (60), qui est en contact directement ou indirectement avec la surface de contact (41', 42') de l'autre borne électrique (41, 42) du capteur de température (40), de sorte que la chute de tension au niveau du capteur de température (40) peut être captée sous la forme d'un signal de température par le biais de la différence de tension entre le premier et le deuxième contact externe (210, 220).

15. Module de puissance électronique (200) selon l'une quelconque des revendications 12 à 14, **caractérisé en ce que** les contacts externes (210, 220) électriques sont réalisés sous la forme de broches de signal.
